# EUROPEAN PATENT APPLICATION

(11) **EP 1 187 213 A2**
(43) Date of publication of application: **13.03.2002**
(21) Application number: 01203218.1
(22) Date of filing: 27.08.2001
(51) Int. Cl.: H01L 27/00

(54) **Power generating display device**

(30) Priority: 06.09.2000 US 656251
(71) Applicant: EASTMAN KODAK COMPANY, Rochester, New York 14650 (US)
(72) Inventor: Williams, David J., Eastman Kodak Company, Rochester, New York 14650-2201 (US); Burtis, John, Eastman Kodak Company, Rochester, New York 14650-2201 (US); Cok, Ronald S., Eastman Kodak Company, Rochester, New York 14650-2201 (US); Tang, Ching W., Eastman Kodak Company, Rochester, New York 14650-2201 (US)
(74) Representative: Nunney, Ronald Frederick Adolphe

(57) **Abstract**

A power generating display device, includes a photoelectric cell for generating electrical energy; and a display panel having light transmissive, light emitting OLED display elements and a light transmissive substrate located over the photoelectric cell.

## Description

The present invention relates to a system incorporating a transparent display device integrated with a mechanism for the creation of electricity from ambient light.

Digital display devices for both imagery and graphics are well known and used in a myriad of applications. A wide variety of technologies support information display including cathode ray tubes, plasma displays, and liquid crystal displays. More recently organic light emitting diodes (OLEDs) have been developed and provide a thin, robust, and high-quality technology for information display. These organic devices can be built upon a variety of substrates, including glass and steel. Moreover, processes used for the manufacture of OLED displays are very similar to conventional integrated circuit technologies, enabling high efficiency manufacturing at relatively low cost.

One method for the creation of OLED display devices utilizes the deposition of silicon materials and contact layers upon a transparent substrate. The contacts can be transparent and may be constructed of, for example, indium tin oxide (ITO). Organic, light-emissive materials are then deposited upon the contact layers. These organic materials can also be transparent. The entire device is then encapsulated and sealed. US Patent 5,776,623 issued July 7, 1998 to Hung et al. describes such a system.

Suitably biased organic electro-luminescent devices (OELs) have also been demonstrated to be responsive to the presence of light. For example, US Patent 5,929,845, issued July 27, 1999 to Wei et al. describes a system which both emits and detects light using an organic electro-luminescent apparatus. Although the transparent organic emissive materials may emit only a limited frequency range of light, other absorptive materials can absorb a very broad spectrum and respond photo-electrically to the presence of light.

Because the processes used to manufacture OLED displays are compatible with the traditional integrated circuit processes, digital computing devices such as transistors, capacitors, diodes, interconnects, etc., can also be integrated within these devices.

Solar cell technology utilizes similar processes - silicon (either bulk or thin-film) deposited on a substrate with at least one transparent electrode and a transparent cover. When these devices are exposed to light, they produce electricity (see US Patent 4,281,208 issued July 28, 1981 to Kuwano et al.). The electricity can be used to operate a device, charge a device, or supplement another power supply. This technology is used for both industrial, high-power applications and in small, portable, battery-powered devices, such as calculators. A wide variety of such devices incorporating both photoelectric and display mechanisms are known. For example, US Patent 5,354,979 issued October 11, 1994 to Adelson et al. describes a memory device with a photoelectric transducer adapted to providing power to the device, as well as an optional power source. US Patent 5,039,928 issued August 13, 1991 to Nishi et al. teaches a portable computer with a solar energy accumulator which can be mounted upon the computer or detached from the computer. Some display devices are self-powering, accumulating energy during the day when ambient illumination is strong and operating at night (US 4,718,185 issued January 12, 1988 to Conlin et al. and US Patent 5,618,100 issued April 8, 1997 to Glynn). US Patent 5,957,564 issued September 28, 1999 to Bruce et al. describes such a system applied to electro-luminescent lighting displays. However, in all cases, the available power in the device and, in particular the power storage lifetime, limit the usefulness, portability, and operating time of the device.

Portable electronic display devices incorporating batteries are also becoming increasingly small and light weight, for example, cell phones, personal digital assistants, digital cameras, lap top computers, etc. Many of these devices are reaching the point at which human interface constraints - the size of the finger, the acuity of the eye - are limiting the continuing size reduction of the devices. For such applications, surface space on a physical device is critical. In particular, devices incorporating displays and keypads are constrained. Moreover, such portable devices also have limited power and must be recharged frequently; this need for recharging limits the use of the device. To address such needs US Patent 5,990,995 issued November 23, 1999 to Ebihara et al. describes the use of a reflective liquid crystal display device with a light absorbing layer placed beneath the reflecting layer. The light absorbing layer is used to generate power from ambient radiation. However, this approach is very limited in that the bulk of the light is lost due to the reflective layer and power can only be generated when the display is operating in a transparent state.

There is a need therefore for an improved portable display system incorporating increased power availability without reducing the available surface space when incorporated into a device.

This need is met according to the present invention by providing a power generating display device, including a photoelectric cell for generating electrical energy; and a display panel having light transmissive, light emitting OLED display elements and a light transmissive substrate located over the photoelectric cell.
Fig. 1 is a schematic illustration of a power generating display device according to the present invention;
Fig. 2 is a schematic illustration of the power generating display device in a portable telephone;
Fig. 3 is a cross sectional view of a preferred embodiment of the power generating display device according to the present invention; and
Fig. 4 is an illustration of a multi-layer display and photoelectric device including transparent contacts, emissive, and semiconductor layers according to the present invention wherein the entire device has photoelectric capability but only a portion is capable of emission.

The foregoing problems associated with the need for power and accessible space in a portable, battery-powered display device can be met by integrating a transparent OLED display on top of a photoelectric energy collector. The photoelectric energy collector generates electricity when exposed to light and can be used to supplement the power needed for the display in operation and used as a recharging mechanism for a power storage device when the device is not in use.

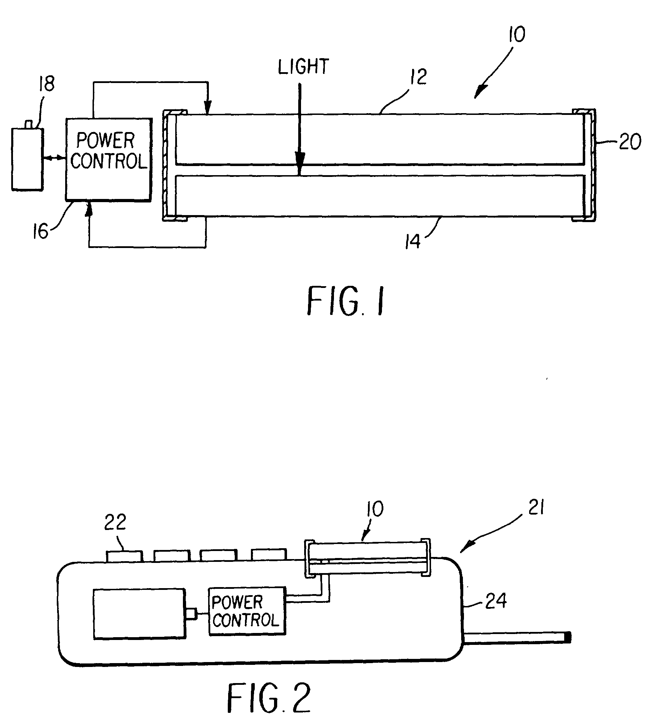

Referring to Fig. 1 a power generating display device **10** includes a transparent OLED display panel **12** located directly above a photoelectric cell **14**. The photoelectric cell **14** can be affixed directly to the display panel **12**, for example, by using a transparent adhesive material or alternatively, the two components can be placed in a common frame **20** that locates them in close alignment. Conventional power control electronics **16** are connected to the photoelectric cell **14**, the display panel **12**, and a conventional power supply **18** such as a battery or a capacitor. When exposed to light, photons will pass through the display panel **12** to the photoelectric cell **14** to produce current. The current is supplied to the power control electronics **16** either to help power the display panel **12** when it is in use or to charge the power supply **18** when not in use.

The power generating display device **10** of Fig. 1 can be integrated within a system, for example a portable telephone as shown in Fig. 2. In Fig. 2, a telephone **21** includes a keypad **22**, case **24**, and display device **10.** Because the photoelectric cell **14** is placed directly beneath the display panel **12,** no additional surface space on the telephone **20** is needed, although room within the system for the photoelectric cell is required, and the system will be heavier and larger in consequence.

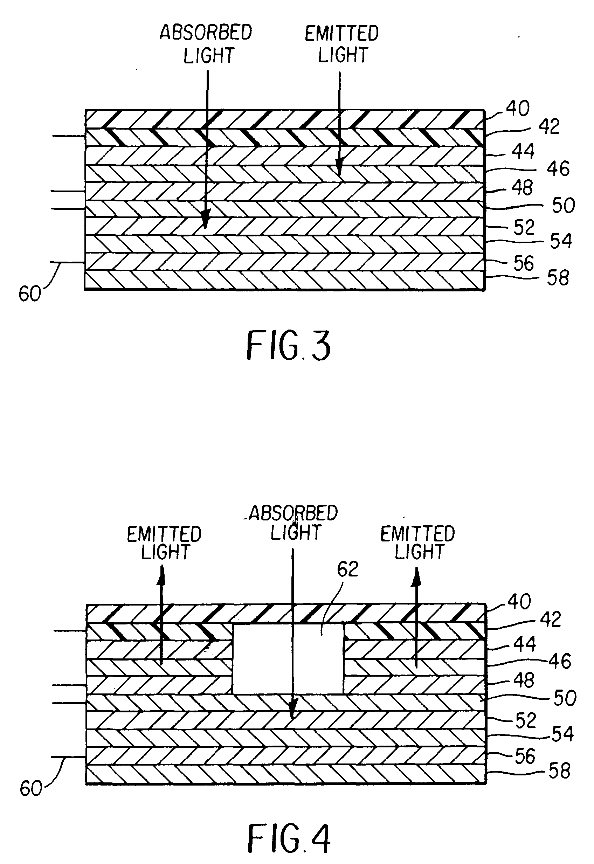

In a preferred embodiment of the present invention, common processes, substrate materials, and light-responsive elements are utilized to create a completely integrated power generating display device, as shown in Fig. 3. The display device is manufactured on a transparent substrate **40**. A patterned transparent conductive contact layer **42** followed by a patterned hole transport layer **44**, a patterned emissive layer **46**, and a second patterned transparent conductive contact layer **48** are formed on the support. These layers comprise the display portion of the unit. A third transparent conductive contact layer **50** is then formed and a semiconductor layer of one conductivity type (e.g. an n-layer **52**) and a second semiconductor layer of opposite conductivity type (e.g. a p-layer **54**) are formed on the device. A fourth transparent conductive contact layer **56** is then covered by a back plate **58**. Back plate **58** can be, for example, enamel coated steel plate, plastic or glass. The n and p layers **52** and **54** are preferably composed of organic materials. Alternatively, the photoelectric materials are traditional crystalline silicon, polysilicon, or amorphous silicon materials whose deposition and processing are compatible with the display elements. Any other compatible photoelectric materials may also be used.

Alternatively, the display device may be constructed by building the layers described above on the back plate **58.** If silicon photoelectric materials are used and, depending on the manufacturing process used, it may be preferable to construct the photoelectric layers first. Moreover, an additional transparent layer, such as glass, may be desired between the second conductive contact layer **48** and the third conductive contact layer **50**. This integrated process simplifies the fabrication process and enhances the robustness of the complete device.

Regardless of the composition of the photoelectric materials or whether or not the display is in use, incident light travels through the organic emissive materials and contacts and strikes the semiconductor materials **52** and **54**, creating an electrical current. Independently of the photoelectric material, when the display layers are in active use, the emissive material **46** is energized via the contacts **42, 48** and emits light through the glass cover **40.** Any light reflected back from the cover into the device can likewise pass through to the photoelectric cell and be converted to electricity. The connections to the contact layers are illustrated with wires **60** and connect to the power control electronics **16** of Fig. 1.

Alternatively, a backing of photoelectric materials as shown in Fig. 4 can also be used for all areas of the device while only a portion of the device is emissive. Any space **62** in the regions between emissive areas can be filled with an inert transparent material.

The present invention can be applied to both passive and active matrix display devices. For either case, the area of the display device that is covered by logic devices and supporting material (transistors, resistors, capacitors, conductors, etc.) is not capable of emitting light and will reduce the fill factor of the display area and the photoelectrically responsive area. These logic devices, while necessary, will reduce the efficiency of the device, both as an emitter and power collector and should be minimized as much as possible.

Organic Light Emitting Diodes (OLEDs) including small molecule polymeric OLEDs as disclosed in but not limited to US Patent 4,769,292 issued September 6, 1988 to Tang et al. and US Patent 5,061,569 issued October 29, 1991 to VanSlyke et al. provide a technical platform on which a suitable display device can be created. Many combinations and variations of OLED materials would be apparent to those knowledgeable in the art and can be used to fabricate such a device and are included in this invention.

The present invention provides a highly integrated, small, and light weight means to supplement the power of portable display devices without requiring additional surface area on the device, enhance the power lifetime of the device between recharging cycles, and maintaining the usability of the device.

## Claims

1. A power generating display device, comprising:
a) a photoelectric cell for generating electrical energy; and
b) a display panel having light transmissive, light emitting OLED display elements and a light transmissive substrate located over the photoelectric cell.

2. The power generating display device claimed in claim 1 further comprising a transparent adhesive layer between the photoelectric cell and the display panel securing the photoelectric cell to the display panel.

3. The power generating display device claimed in claim 1 further comprising a frame locating the photoelectric cell with respect to the display panel.

4. The power generating display device claimed in claim 1, wherein the display panel has either active or passive matrix control.

5. The power generating display device claimed in claim 1, wherein the photoelectric cell is a crystalline silicon, polysilicon, or amorphous silicon photoelectric device.

6. The power generating display device claimed in claim 1, wherein the photoelectric cell is an OLED photoelectric device.

7. The power generating display device claimed in claim 1, wherein the photoelectric cell and the display panel are integrated on a common substrate.

8. The power generating display device claimed in claim 7, wherein the power generating display device comprises, in order:
a) a first transparent contact layer on the transparent substrate for energizing the display elements;
b) a transparent hole transport layer;
c) a transparent organic emissive layer;
d) a second transparent contact layer for energizing the display element;
e) a third transparent contact layer for receiving photoelectric current;
f) a semiconductor layer of a first conductivity type;
g) a semiconductor layer of a second conductivity type; and
h) a fourth contact layer.

9. The power generating display device claimed in claim 8 wherein the semiconductor layers are formed from amorphous silicon.

10. The power generating display device claimed in claim 8 wherein the semiconductor layers are formed from organic materials.

11. The power generating display device claimed in claim 1 wherein the display elements cover only a portion of the substrate.

12. The power generating display device claimed in claim 8 further comprising a transparent electrically insulating layer between the second transparent contact layer and the third transparent contact.

13. The power generating display device claimed in claim 1, further comprising a power supply and power control electronics connected to power supply, the photoelectric cell and the display panel.

14. The power generating display device claimed in claim 13, wherein the power supply is a battery.

15. The power generating display device claimed in claim 13, wherein the power supply is a capacitor.
